# DEMANDE DE BREVET EUROPEEN

(11) **EP 1 231 642 A1**
(43) Date de publication de la demande: **14.08.2002**
(21) Numéro de dépôt: 02354027.1
(22) Date de dépôt: 11.02.2002
(51) Int. Cl.: H01L 27/146, H01L 27/144, H01L 31/0352

(54) **Photodétecteur à trois transistors**

(30) Priorité: 12.02.2001 FR 0101880
(71) Demandeur: STMicroelectronics S.A., 92120 Montrouge (FR)
(72) Inventeur: Roy, Francois, 38000 Grenoble (FR)
(74) Mandataire: de Beaumont, Michel

(57) **Abrégé**

L'invention concerne un photodétecteur réalisé sous forme monolithique, du type comportant une photodiode, un transistor MOS de précharge, un transistor MOS de commande et un transistor MOS de lecture, la photodiode et le transistor de précharge étant réalisés dans un même substrat d'un premier type de conductivité, la photodiode comprenant une première région du deuxième type de conductivité formée sous une deuxième région du premier type de conductivité, plus fortement dopée que le substrat, et sous une troisième région du deuxième type de conductivité, plus fortement dopée que la première région, les deuxième et troisième régions étant disjointes, la première région constituant la région de source du deuxième type de conductivité du transistor MOS de précharge, les deuxième et troisième régions étant reliées, respectivement, à un potentiel fixe et à la grille du transistor de commande.

## Description

La présente invention concerne la réalisation sous forme monolithique de photodétecteurs ou capteurs d'images destinés à être utilisés dans des dispositifs de prise de vues tels que, par exemple, des caméras, des camescopes, des microscopes numériques ou encore des appareils photographiques numériques. Plus particulièrement, la présente invention concerne des capteurs d'images à base de semiconducteurs comportant un unique élément de stockage et de photodétection.

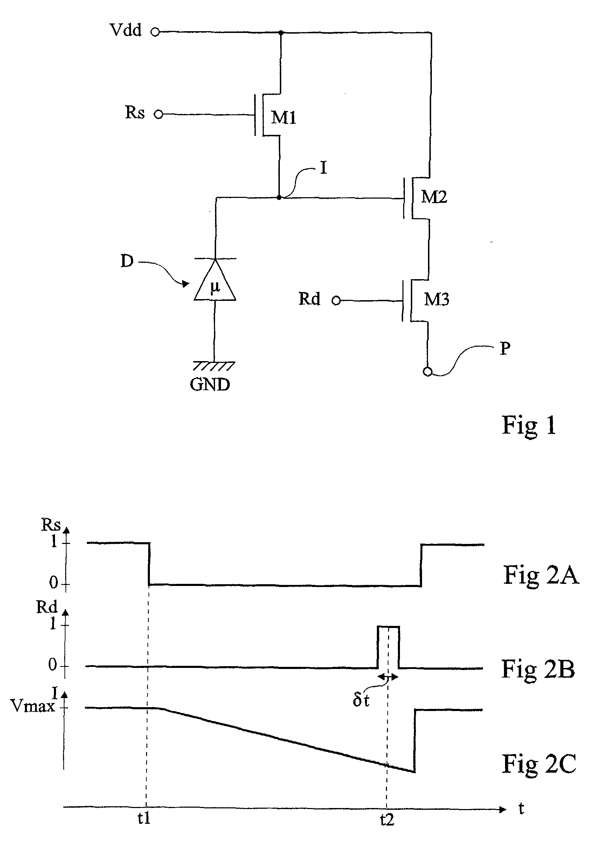

La figure 1 illustre le schéma de principe d'un tel capteur d'images. L'homme de l'art comprendra qu'un dispositif réel comprend une pluralité ou matrice de tels capteurs. Un capteur élémentaire comporte, interconnectés en série entre un rail d'alimentation haute Vdd et un rail d'alimentation basse de référence ou masse du circuit intégré GND, un transistor MOS à canal N de précharge M1 et une photodiode D. On désigne par I le noeud de connexion de la photodiode D et du transistor de précharge M1.

Le capteur comporte également deux transistors MOS à canal N M2 et M3, en série entre l'alimentation haute Vdd et une borne d'entrée P d'un circuit de traitement électronique de données (non représenté). On désigne ci-après par M2 celui des deux transistors dont une borne de source/drain est reliée à l'alimentation haute Vdd. Le transistor M3, dont une borne est reliée à la borne P, constitue un transistor de lecture. La grille du transistor M2 est reliée au noeud I. La grille du transistor de précharge M1 peut recevoir un signal de précharge Rs. La grille du transistor de lecture M3 peut recevoir un signal de commande de lecture Rd.

Les figures 2A, 2B et 2C illustrent par des chronogrammes l'évolution dans le temps respectivement du signal de commande de précharge Rs, du signal de commande de lecture Rd et du niveau de tension du noeud I.

On considérera ci-après que les transistors M1 et M3 sont fermés quand leur signal de grille est à niveau haut (1) et qu'ils sont bloqués lorsque ce signal est à niveau bas (0).

Un cycle de fonctionnement du capteur commence par le maintien à l'état bloqué du transistor de lecture M3, comme l'illustre l'état bas (0) du signal de lecture Rd en figure 2B. Par contre, le transistor de précharge M1 est passant, comme l'indique l'état haut (1) du signal de précharge Rs en figure 2A. Dans cet état, le noeud I se charge à une tension maximale Vmax qui correspond sensiblement à la valeur Vdd de l'alimentation haute.

On considère un instant t1 auquel l'état de précharge est atteint sur le noeud I. Le signal de commande de précharge est alors ramené à niveau bas, et le transistor de précharge M1 se bloque. A partir de cet instant t1, le noeud I se décharge plus ou moins rapidement selon l'éclairement de la photodiode D.

A un instant t2, alors que le transistor de précharge M1 est toujours bloqué, on effectue une lecture de l'état de la cellule en rendant brièvement passant le transistor de lecture M3. Pour ce faire, comme l'illustre la figure 2B, on applique sur sa grille un signal de lecture Rd à l'état haut pendant un intervalle de temps bref δt centré sur l'instant t2. Le niveau de sortie transmis sur la borne P dépend de l'état de charge de la grille du transistor M2, c'est-à-dire du potentiel au noeud I et donc de la charge stockée en ce point. La sortie P est appliquée à l'entrée d'un circuit électronique de traitement qui fournit une indication de l'éclairement de la photodiode D entre les instants t1 et t2.

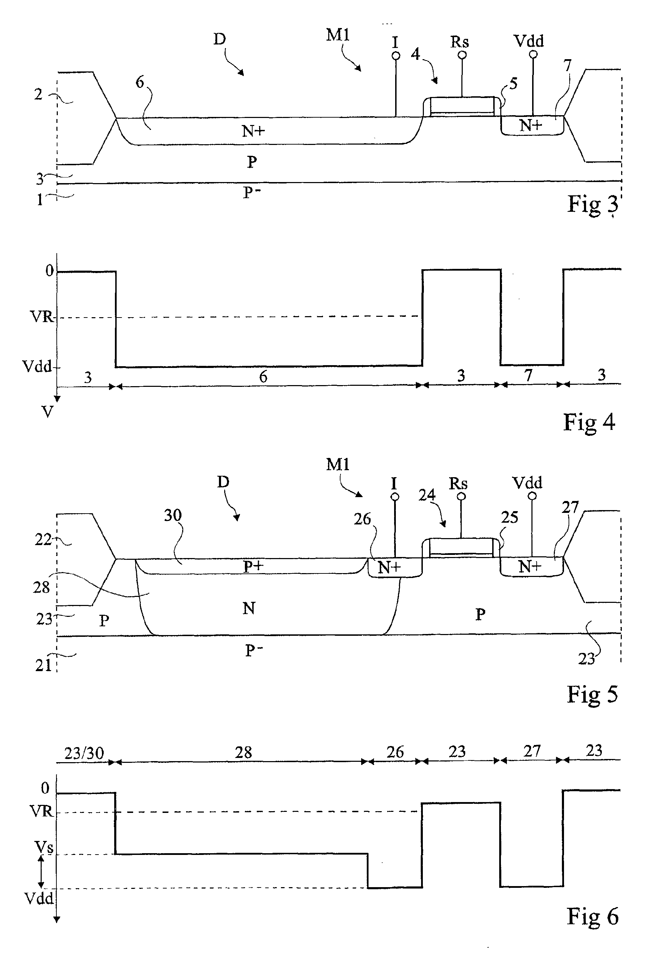

La figure 3 illustre, en vue en coupe partielle et schématique, une réalisation sous forme monolithique de l'ensemble de la photodiode D et du transistor de précharge M1 de la figure 1. Ces éléments sont réalisés dans un substrat semiconducteur 1 d'un premier type de conductivité, par exemple de type P, faiblement dopé (P-). Ce substrat correspond par exemple à une couche épitaxiée sur une plaquette de silicium de type P (non représentée). La zone active est délimitée par des zones d'isolement de champ 2, par exemple en oxyde de silicium (SiO₂), et correspond soit à une partie du substrat 1, soit à un caisson 3 de même type de conductivité que le substrat 1 sous-jacent, mais plus fortement dopé. Au-dessus de la surface du caisson 3 est formée une structure de grille isolée 4 éventuellement munie d'espaceurs latéraux 5. De part et d'autre de la grille 4, à la surface du caisson 3, se trouvent des régions de source 6 et de drain 7 du type de conductivité opposé, par exemple N, fortement dopées (N+). La région de source 6 est réalisée sur une surface beaucoup plus importante que la région de drain 7 et forme avec le caisson 3 sous-jacent la jonction de la photodiode D. La grille 4, la source 6 et le drain 7 sont solidaires de métallisations (non représentées) qui permettent de mettre en contact ces régions respectivement avec le signal de commande de précharge Rs, la grille du transistor M2 (noeud I) et l'alimentation haute Vdd, respectivement. La structure est généralement complétée par une région fortement dopée de type P (non représentée) qui permet de connecter au potentiel de référence ou masse le substrat 1 et le caisson 3.

La figure 4 illustre en traits pleins les niveaux de potentiel des différentes régions de la figure 3 juste après la précharge : les régions 6 et 7 sont au potentiel de précharge, le caisson 3 est à la masse. On a représenté en pointillés le potentiel VR de la région 6 juste avant une lecture alors que des photons ont irradié cette région. Le potentiel de précharge dépend de la polarisation du transistor de précharge M1, c'est-à-dire du niveau du signal Rs appliqué sur sa grille. Si le transistor M1 est en régime ohmique (Rs très grand), les régions 6 et 7 sont préchargées du potentiel Vdd. Si le transistor M1 est en régime de faible inversion, les potentiels des régions 6 et 7 s'alignent sur le niveau du canal du transistor M1.

Un inconvénient de ce type de structure réside en ce que le potentiel maximal de la région 6 après la précharge est mal défini. En effet, à la capacité de la diode, correspond un signal de bruit de précharge dont la valeur en tension est donnée par la relation V=kTC, où k est la constante de Boltzman, T la température et C la capacité de cette diode. Ce bruit doit être pris en compte par le circuit électronique de traitement lors de l'évaluation de l'état de sortie. En effet, pour pouvoir déterminer la baisse de potentiel due à une irradiation, il faut comparer la valeur à l'instant t2 (figure 2) à la valeur maximale de précharge. Ce niveau de précharge étant inconnu, on est amené à mettre en oeuvre des procédés de double échantillonnage corrélés qui imposent de prélever la valeur maximale en fin de précharge. Il faut alors prévoir des systèmes électroniques plus complexes afin de pouvoir effectuer une prise d'échantillon en fin de précharge. Il faut également mémoriser les données ainsi obtenues. Il est alors nécessaire de disposer d'une mémoire supplémentaire de même dimension que la matrice totale du dispositif de prise de vue, d'où il résulte un encombrement important qui limite la miniaturisation des dispositifs. En outre, les traitements électroniques associés sont relativement longs.

La présente invention vise donc à proposer une nouvelle cellule élémentaire qui permette de réduire le temps de traitement.

La présente invention vise également à proposer une telle cellule qui permette une réduction de l'encombrement.

Pour atteindre ces objets, la présente invention prévoit un photodétecteur réalisé sous forme monolithique, du type comportant une photodiode, un transistor MOS de précharge, un transistor MOS de commande et un transistor MOS de lecture, la photodiode et le transistor de précharge étant réalisés dans un même substrat d'un premier type de conductivité, la photodiode comprenant une première région du deuxième type de conductivité formée sous une deuxième région du premier type de conductivité, plus fortement dopée que le substrat, et sous une troisième région du deuxième type de conductivité, plus fortement dopée que la première région, les deuxième et troisième régions étant disjointes, la première région constituant la région de source du deuxième type de conductivité du transistor MOS de précharge, les deuxième et troisième régions étant reliées, respectivement, à un potentiel fixe et à la grille du transistor de commande.

Selon un mode de réalisation de la présente invention, le photodétecteur comprend en outre un caisson du premier type de conductivité, plus fortement dopé que le substrat, dans lequel est formée la première région.

Selon un mode de réalisation de la présente invention, le premier type de conductivité est le type P et le deuxième type de conductivité est le type N.

Selon un mode de réalisation de la présente invention, le substrat, le caisson et la deuxième région sont maintenus à un potentiel de référence bas du circuit.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est un schéma électrique d'un capteur d'images ;
les figures 2A, 2B et 2C sont des chronogrammes qui illustrent l'état de différents signaux pendant un cycle de fonctionnement de la cellule de la figure 1 ;
la figure 3 est une vue en coupe partielle et schématique d'une partie du circuit de la figure 1 réalisée sous une forme monolithique connue ;
la figure 4 illustre des niveaux de potentiels dans la structure de la figure 3 ;
la figure 5 est une vue en coupe schématique et partielle d'une partie du circuit de la figure 1 réalisée sous une autre forme monolithique connue ;
la figure 6 illustre des niveaux de potentiel dans la structure de la figure 5 ;
la figure 7 illustre, en vue en coupe partielle et schématique, la réalisation d'une partie du circuit de la figure 1 selon un mode de réalisation de la présente invention ; et
la figure 8 illustre des niveaux de potentiels dans la structure de la figure 7.

De mêmes éléments ont été désignés par les mêmes références aux différentes figures et, de plus, comme cela est habituel dans la représentation des circuits intégrés, les figures 3, 5 et 7 ne sont pas tracées à l'échelle.

On a déjà proposé, par exemple dans le brevet américain N° 6051447, de remplacer la photodiode classique telle que décrite précédemment en relation avec la figure 3 par une photodiode de type "complètement désertée" (fully depleted).

La figure 5 illustre, en vue en coupe schématique et partielle, une structure de la réalisation sous forme monolithique de l'association en série d'une telle photodiode et d'un transistor de précharge.

Le transistor de précharge M1 et la photodiode D complètement déplétée sont réalisés dans un substrat semiconducteur 21 d'un premier type de conductivité, par exemple de type P, faiblement dopé (P-). Plus particulièrement, le transistor M1 et la photodiode D sont réalisés dans une région active délimitée par des zones d'isolement de champ 22, par exemple de l'oxyde de silicium. Cette zone active correspond soit à une partie du substrat 21, soit à un caisson 23 de type P formé depuis la surface du substrat 21, mais plus fortement dopé que celui-ci et relativement profond. A la surface du caisson 23, à droite de la figure 5, ont été formées, de part et d'autre d'une structure de grille isolée 24 éventuellement munie d'espaceurs latéraux 25, des régions de source 26 et de drain 27 du transistor de précharge M1. Les source 26 et drain 27 sont des régions de type de conductivité opposé à celui du substrat 21, par exemple N, fortement dopées (N+). La grille 24, la région de source 26 et la région de drain 27 sont solidaires de métallisations (non représentées) qui sont respectivement connectées à un circuit de commande de précharge qui délivre le signal de précharge Rs, à la grille du transistor M2, c'est-à-dire le noeud I, et à l'alimentation haute Vdd.

Dans la partie gauche de la figure 5 est formée une région 28 dopée de type N qui s'étend jusqu'au substrat 21 et est en contact avec la région de source 26. Cette région 28 est moins fortement dopée que la source 26.

La région 28, en dehors de son contact avec la source 26 est recouverte d'une région 30 de type P, fortement dopée, également en contact avec le substrat 21 par l'intermédiaire du caisson 23. Le substrat 21 est relié de façon permanente à une alimentation basse de référence ou masse du circuit. Par conséquent, pendant tout le fonctionnement du dispositif, le caisson 23 et la région 30 sont également maintenus au potentiel de référence du circuit.

Typiquement, la région 30 d'une épaisseur de 0,1 µm comporte du bore dans une concentration de 5.10¹⁸ atomes/cm³, alors que la région 28 d'une épaisseur de 0,3 µm, comporte du phosphore dans une concentration de 10¹⁸ atomes/cm³.

Durant la précharge, le transistor M1 est passant et les charges photogénérées dans la région 28 de cathode de la photodiode s'évacuent, via la région de source 26 vers la région de drain 27. L'anode 30 de la diode étant fortement dopée et la région 28 étant relativement mince, la zone de charge d'espace tend à s'étendre dans toute l'épaisseur de la région 28 qui est désertée complètement. La capacité de jonction vue du noeud I est nulle. La photodiode D se comporte comme un condensateur de capacité sensiblement nulle et, pendant la précharge, la région 28 s'autopolarise à une valeur de potentiel Vs fixée uniquement par les dopages relatifs de cette région 28 et de la région de surface 30. Ce potentiel n'est donc théoriquement plus affecté d'un bruit d'alimentation.

La figure 6 illustre les potentiels dans les différentes régions de la figure 5. On se place dans les mêmes conditions que celles de la figure 3. Le comportement du caisson 23 et des régions de source 26 et de drain 27 n'est pas modifié. Dans la région 28, le potentiel de la photodiode est d'au plus Vs, valeur fixe de précharge, inférieure à la valeur de l'alimentation haute Vdd.

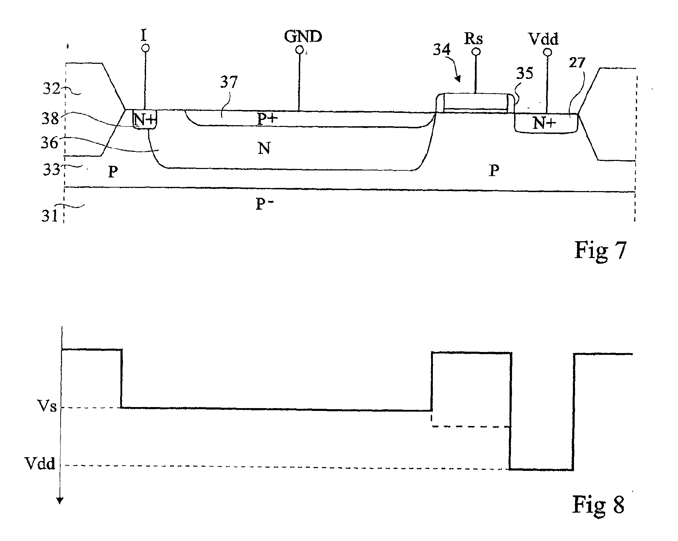

Un inconvénient de cette structure réside dans la différence de potentiels entre la région de source 26 et la région de cathode 28 de la photodiode. En effet, après l'étape de précharge, lors d'un éclairement, le stockage des charges photogénérées commence à s'effectuer dans la région de potentiel le plus haut, c'est-à-dire dans la région de source 26 avant de s'effectuer dans la région de cathode 28. Lors de la lecture ultérieure, comme l'illustre la figure 7E du brevet Kodak susmentionné, tout se passe, vue du noeud I, comme si deux capacités successives se déchargeaient. Alors, il y a une non-linéarité de la commande de la grille du transistor de commande M2. Cette non-linéarité de commande se traduit par une non-linéarité du signal de sortie fourni à la borne P d'entrée du circuit de traitement. Dans le cas de capteurs couleurs, la restitution des différentes couleurs est décalée, ce qui rend impossible un affichage direct. Dans le cas de capteurs noir et blanc, le contraste est particulièrement faible.

En outre, comme précédemment, la région de source 26 est affectée par un bruit de précharge variable dont la valeur en tension est donnée par la relation précédente V=kTC.

Ces effets de capacité parasite sont encore renforcés du fait de la métallisation de connexion de la région 26 au noeud I.

La présente invention vise donc à proposer une nouvelle structure qui permette de pallier les inconvénients exposés précédemment.

La figure 7 illustre, en vue en coupe schématique et partielle, une réalisation sous forme monolithique d'une photodiode selon la présente invention associée à un transistor de précharge.

Le transistor de précharge M1 (figure 1) et la photodiode D selon la présente invention sont réalisés dans un substrat semiconducteur 31 d'un premier type de conductivité, par exemple de type P, faiblement dopé (P-). Plus particulièrement, le transistor M1 et la photodiode D sont réalisés dans une région active délimitée par des zones d'isolement de champ 32, par exemple de l'oxyde de silicium (SiO₂). Cette zone active correspond soit à une partie du substrat 1, soit à un caisson 33 de type P formé depuis la surface du substrat 31, mais plus fortement dopé que celui-ci et relativement profond. A la surface du caisson 33, à droite de la figure 7, ont été formés, de part et d'autre d'une structure de grille isolée 34 (grille du transistor M1), éventuellement munie d'espaceurs latéraux 35, des régions de source 36 et de drain 27 du transistor de précharge M1. Les source 36 et drain 27 sont des régions de type de conductivité opposé à celui du substrat 31, par exemple N. Le drain 27, représenté à droite de la grille 34, est fortement dopé (N+) et est solidaire d'une métallisation non représentée, connectée à l'alimentation haute Vdd. La grille 34 est solidaire d'une autre métallisation non représentée, connectée à un circuit de commande de précharge qui délivre le signal de précharge Rs. La source 36 du transistor M1, représentée à gauche de la grille 34, est une région plus faiblement dopée, de surface beaucoup plus importante et plus profonde que le drain 27. La source 36 constitue la cathode de la photodiode D. La photodiode D est du type complètement déplétée et la région 36 comporte une région de surface de type P 37, peu profonde et fortement dopée (P+). La région 37 est connectée, en dehors de la région représentée, à l'alimentation de référence GND. La source 36 comporte également une deuxième région de surface 38 disjointe de la région 37. La région 38 est dopée du même type de conductivité que la région 36, par exemple N, mais plus fortement (N+). La région 38 est uniquement destinée à assurer un contact fortement conducteur avec une métallisation (non représentée) permettant de connecter la source 36 au noeud I. La région 38 est formée à l'écart de la région de canal du transistor de précharge M1, sous-jacente à la grille 34 de celui-ci. Les dimensions de la région 38 peuvent par conséquent être réduites au strict minimum lithographiquement possible. La région 38 présente donc des dimensions nettement réduites par rapport à la région de drain 27.

Lors d'une opération de précharge, ou à la fin d'une opération de lecture, l'ensemble de la région 36 et de la région 38 s'autopolarise de façon uniforme à la valeur de repos ou potentiel de déplétion Vs de la photodiode D.

Un tel potentiel de déplétion Vs est parfaitement défini par les seules conditions de fabrication du composant et demeure parfaitement stable en fonctionnement. Par conséquent, la valeur atteinte en fin de chaque précharge est parfaitement stabilisée. On s'affranchit ainsi avantageusement du bruit de précharge kTC décrit précédemment.

Ceci permet de simplifier le traitement électronique des données. En effet, la valeur de précharge de la source du transistor M1 étant parfaitement stabilisée, il n'est plus nécessaire de comparer l'état lu à une valeur mémorisée en fin de précharge, pour effectuer une double corrélation. Cela réduit les temps de traitement et augmente donc la fréquence possible de prises de vue.

Un avantage est encore qu'il n'est plus nécessaire de disposer d'une matrice de stockage des données intermédiaires. L'encombrement du système est donc réduit. Cela permet dualement de réduire les dimensions du dispositif global ou d'accroître les dimensions de la matrice de mesure. Une augmentation des dimensions permet d'accroître la sensibilité du dispositif.

Bien entendu, la présente invention est susceptible de diverses variantes et modifications qui apparaîtront à l'homme de l'art. En particulier, l'homme de l'art saura ajuster les niveaux et types de dopage aux performances recherchées et aux matériaux utilisés en fonction des contraintes d'une technologie de fabrication particulière.

## Revendications

1. Photodétecteur réalisé sous forme monolithique, du type comportant une photodiode (D), un transistor MOS de précharge (M1), un transistor MOS de commande (M2) et un transistor MOS de lecture (M3), la photodiode et le transistor de précharge étant réalisés dans un même substrat (31) d'un premier type de conductivité, **caractérisé en ce que** la photodiode comprend une première région (36) du deuxième type de conductivité formée sous une deuxième région (37) du premier type de conductivité, plus fortement dopée que ledit substrat, et sous une troisième région (38) du deuxième type de conductivité, plus fortement dopée que ladite première région, les deuxième et troisième régions étant disjointes, la première région constituant la région de source du deuxième type de conductivité du transistor MOS de précharge, les deuxième et troisième régions étant reliées, respectivement, à un potentiel fixe (GND) et à la grille (I) dudit transistor de commande.

2. Photodétecteur selon la revendication 1, **caractérisé en ce qu'**il comprend en outre un caisson (33) du premier type de conductivité, plus fortement dopé que ledit substrat (31), dans lequel est formée la première région (36).

3. Photodétecteur selon la revendication 1, **caractérisé en ce que** le premier type de conductivité est le type P et le deuxième type de conductivité est le type N.

4. Photodétecteur selon la revendication 2, **caractérisé en ce que** le substrat (31), le caisson (33) et la deuxième région (37) sont maintenus à un potentiel de référence bas (GND) du circuit.
